# EUROPEAN PATENT APPLICATION

(11) **EP 4 550 418 A1**
(43) Date of publication of application: **07.05.2025**
(21) Application number: 23206960.9
(22) Date of filing: 31.10.2023
(51) Int. Cl.: H01L 23/552, H01L 23/66, H01L 25/07, H01L 23/498

(54) **POWER SEMICONDUCTOR DEVICE AND METHOD FOR PRODUCING A POWER SEMICONDUCTOR DEVICE**

(71) Applicant: Hitachi Energy Ltd, 8050 Zürich (CH)
(72) Inventor: SANTOLARIA, Lluis, 4600 Olten (CH); MESEMANOLIS, Athanasios, 8404 Wintherthur (CH); BEYER, Harald, 5600 Lenzburg (CH)
(74) Representative: Epping - Hermann - Fischer

(57) **Abstract**

A power semiconductor device (1) is provided, with
- a power line (16) electrically connected to a power terminal (17), and
- an auxiliary loop structure (2) comprising
- at least two auxiliary terminals wherein one of the at least two terminals is a gate terminal (),
- at least two auxiliary signal lines (3, 4) comprising a first auxiliary signal line and a second auxiliary signal line where the first auxiliary signal line is electrically connected to the power terminal (17) and the second auxiliary signal line is a gate line (4) electrically connected to the gate terminal, and the at least two auxiliary signal lines (3, 4) are spaced apart from one another and extend at least regionally parallel to each other, and
- a first shielding portion (5) for shielding one of the at least two auxiliary signal lines (3, 4) from an electromagnetic field of the power line (16), formed electrically conductively, spaced apart from the shielded auxiliary signal line (4), and extending at least regionally parallel to the at least two auxiliary signal lines (3, 4), wherein
- the at least two auxiliary signal lines (3, 4) at least regionally overlap with each other where a first surface of the shielded auxiliary signal line (3, 4) is covered by the other auxiliary signal line (3, 4), and
- the first shielding portion (5) at least regionally overlaps with a second surface of the shielded auxiliary signal line (3, 4).

Furthermore, a method for producing a power semiconductor device (1) is provided.

## Description

The present disclosure relates to a power semiconductor device and a method for producing a power semiconductor device.

As the development of power semiconductor devices evolves towards higher switching frequencies, parasitic inductances affect not only the power circuit itself, but also typical auxiliary circuitries. In particular, inductances are always present, but their impact is getting stronger for higher switching frequencies or switching velocities. This can be also an issue at low frequencies, but at steep current ramps, wherein dI/dt is relevant.

A gate inductance (self inductance of a typical gate loop) has an impact on the increase or decrease of the gate voltage during switching, such that it has a strong impact on the switching frequency and/or velocity and consequently on the generation of oscillations. In general, the gate inductance should be minimized.

Further, changes of the electric current in a main loop or a power loop in a power semiconductor device, for e.g. the current flowing through a collector & emitter terminals in a IGBT device or a source & drain terminals in a MOSFET device creates a fast changing electromagnetic field which interacts with signal/power lines or/and loops in the circuitry within the power semiconductor device. An example of changes of the electric current in a main loop is a change due to changing of the current from a positive (DC+) to a negative (DC-) power during switching. Such a change in the electric current in a power loop provide a magnetic field which couples to the gate loop, i.e. is a coupling commutation in a circuit loop involving the electrical connections with the gate, for example a circuit loop formed with a gate line and auxiliary emitter/source line in the power semiconductor device.

Such circuit loops formed by the auxiliary signal lines including gate signal lines and auxiliary emitter/source lines are loops carry low current (signal current). These loops can have a high susceptibility to electromagnetic fields produced by a switching operation affecting the main electrical current in the power semiconductor device. Therefore, the auxiliary loop, for example the loop formed with a gate terminal/line together with an emitter/source terminal/line or a loop formed with a measurement signal line from a sensor placed in the power semiconductor device need to be designed to minimize susceptibility to electromagnetic fields from the power loop carrying the switching current formed with emitter/collector terminals or a source/drain terminals in the power semiconductor device. In this patent application, the terminals carrying the switching current (current in the main/power current path) are referred to as Power terminals, for example emitter and collector terminals in an IGBT device and source and drain terminals in a MOSFET device.

The electromagnetic effect has an impact on the switching velocity, such that switching becomes faster (slower) in the case of a positive (negative) coupling. Differences in the coupling commutation of high side and low side devices are relevant for the switching homogeneity of the power semiconductor devices. Furthermore, a slightly negative coupling commutation should be achieved.

Embodiments of the disclosure relate to a power semiconductor device which has improved electromagnetic properties. A further embodiment relates to a method for producing such a power semiconductor device.

This is achieved by the subject-matter of the independent claims. Further embodiments are evident from the dependent claims and the following description.

A power semiconductor device is described. The term "power" here and in the following, for example, refers to power semiconductor devices and/or power semiconductor chips adapted for processing voltages and currents of more than 100 V and/or more than 10 A, exemplary voltages up to 10 kV and electrical currents up to 10 kA.

The power semiconductor device comprises, for example, at least one power semiconductor chip. The power semiconductor chip comprises, for example, a semiconductor material such as at least one of silicon (Si), silicon carbide (SiC), and gallium nitride (GaN). The power semiconductor chip is, for example, a power diode and/or a power metal insulating semiconductor field-effect transistor, power MISFET for short. The term MISFET shall also comprise MOSFETs, which have an oxide as insulating material at a gate. The power semiconductor chip may also be an insulated-gate bipolar transistor, IGBT.

Exemplarily, the power semiconductor device comprises an emitter terminal or a source terminal. In particular, the emitter terminal or the source terminal is a main terminal or a power terminal of the power semiconductor device. Exemplarily, the emitter terminal is electrically connected to an emitter region of the power semiconductor chip. Exemplarily, the source terminal is electrically connected to a source region of the power semiconductor chip. If the power semiconductor chip is a MOSFET, the power semiconductor device comprises the source terminal. If the power semiconductor chip is an IGBT, the power semiconductor device comprises the emitter terminal.

In particular, the emitter terminal or the source terminal is electrically conductive and exemplarily comprise a metal or a metallic alloy.

According to the embodiment, the power semiconductor device comprises a power line electrically connected to power terminals, for example to a drain terminal or a collector terminal. In particular, the power semiconductor device comprises the drain terminal or the collector terminal. Exemplarily, the drain terminal is electrically connected to a drain region of the power semiconductor chip. Exemplarily, the collector terminal is electrically connected to a collector region of the power semiconductor chip. In particular, the power line is electrically conductively connected to the drain region or the collector region via the drain terminal or the collector terminal. Similarly, the power line is electrically connected to the emitter or source terminal of the power semiconductor device. Thus, the power lines are configured to carry main electrical current through the power semiconductor chip.

If the power semiconductor chip is a MOSFET, the power semiconductor device comprises the source and drain terminals. If the power semiconductor chip is an IGBT, the power semiconductor device comprises the emitter and collector terminals.

In particular, the power line is electrically conductive and exemplarily comprises a metal or a metallic alloy.

According to the embodiment, the power semiconductor device comprises an auxiliary loop structure comprising at least two auxiliary terminals wherein one of the at least two terminals is a gate terminal and at least two auxiliary signal lines comprising a first auxiliary signal line and a second auxiliary signal line where the first auxiliary signal line is electrically connected to the power terminal (for example, emitter or source terminals depending on if the switching device is an IGBT or a MOSFET in the power semiconductor device). The gate terminal is, for example, electrically conductively connected to a gate region of the power semiconductor chip. In particular, the gate terminal is electrically conductive and exemplarily comprises a metal or a metallic alloy.

The at least two auxiliary signal lines are exemplarily configured to provide or to detect a voltage signal and/or a current signal from the power terminal and/or gate terminal in order to control, protect and/or monitor the power semiconductor chip. In particular, the auxiliary signal line is configured for detection of a gate-emitter voltage or gate-source voltage being used for control purposes. This means that a safe and efficient operation of the power semiconductor chip is achieved due to the auxiliary signal lines.

The power semiconductor chip is arranged, for example, on a carrier. Exemplarily, the carrier comprises a printed circuit board and/or a lead frame comprising a plurality of signal lines. In particular, the carrier comprises an electrically insulating substrate, including an isolating sheet comprising a ceramic or resin. The first auxiliary signal line is, for example, electrically connected to one of the signal lines of the carrier, e.g. a first signal line. Further, the power terminal is, for example, electrically connected to the one of the signal lines, e.g. the first signal line. This means that the first auxiliary signal line is connected to the power terminal via the carrier.

In particular, the auxiliary signal lines each are electrically conductive and exemplarily comprises a metal such as copper or a metallic alloy such as a copper alloy.

According to the embodiment of the auxiliary loop structure, the second auxiliary signal line is a gate line (4) electrically connected to the gate terminal, and the at least two auxiliary signal lines are spaced apart from one another and extend at least regionally parallel to each other. The gate line is exemplarily configured to provide a gate voltage signal and/or gate current signal to the gate terminal.

The gate line is, for example, electrically connected to one of the signal lines of the carrier, e.g. a second signal line. Further, the gate terminal is, for example, electrically connected to said one of the signal lines, e.g. the second signal line. This means that the gate line is connected to the gate terminal via the carrier.

For example, the first auxiliary signal line and the gate line have a distance to one another. In particular, the first auxiliary signal line and the gate line are electrically insulated from one another.

Exemplarily, the first auxiliary signal line comprises a plurality of sections, wherein directly neighbouring sections enclose an angle of between more than 0° and less than 180°. The gate line extends, for example, parallel to at least one of the sections of the first auxiliary signal line. For example, the gate line comprises a plurality of further sections, wherein directly neighbouring further sections enclose an angle of between more than 0° and less than 180°. Exemplarily, at least some of the further sections are parallel to at least some of the sections. In particular, each of the further sections is parallel to one of the sections.

"Parallel" means here that the first auxiliary signal line and the gate line, in particular the sections and the further sections thereof, each have a main extension direction being approximately parallel. "Approximately" means here that the main extension directions can have an angle of at most 5° or at most 1° due to production tolerances.

In particular, the gate line is electrically conductive and exemplarily comprises a metal such as copper or a metallic alloy such as a copper alloy.

The first auxiliary signal line and/or the gate line has, for example, a width corresponding to a minimal extension in the respective main extension plane of at least 1 mm and at most 15 mm. Exemplarily, the first auxiliary signal line and/or the gate line has, for example, a thickness corresponding to a minimal extension perpendicular to the respective main extension plane of at least 0.3 mm and at most 2 mm.

According to the embodiment, the auxiliary loop structure comprises a first shielding portion for shielding one of the at least two auxiliary signal lines from an electromagnetic field of the power line, formed electrically conductively, spaced apart from the shielded auxiliary signal line, and extending at least regionally parallel to the at least two auxiliary signal lines. For example, the first shielding portion and the shielded auxiliary signal line have a distance to one another. In particular, the first shielding portion and the shielded auxiliary signal line are electrically insulated from one another. Exemplarily, also the first shielding portion and the other auxiliary signal line have a distance to one another.

Exemplarily, at least some of the sections or all of the sections of the first auxiliary signal line are provided with the first shielding portion.

According to the embodiment, the at least two auxiliary signal lines at least regionally overlap with each other where a first surface of the shielded auxiliary signal line is covered by the other auxiliary signal line. In particular, the first auxiliary signal line and the gate line each have a first main surface and a second main surface being connected by a first side surface and a second side surface.

Exemplarily, the first main surface and the second main surface extend along the respective main extension plane and the first side surface and the second side surface extend traverse to the respective main extension plane. Exemplarily, the first surface of the gate line is formed of the first main surface, the second main surface, the first side surface or the second side surface.

Exemplarily, a predetermined direction is defined perpendicular to the main extension plane of the first auxiliary signal line. The first auxiliary signal line and the gate line overlap at least regionally in view along the predetermined direction, for example. In particular, a least one of the sections of the first auxiliary signal line and the gate line overlap at least regionally or completely in view along the predetermined direction.

Exemplarily, the main extension plane of the first auxiliary signal line and the main extension plane of the gate line extend parallel to one another, in particular within the limits of production tolerances as described analogously above.

According to the embodiment, the first shielding portion overlaps at least regionally with a second surface of the shielded auxiliary signal line. Exemplarily, the first shielding portion extends within a further first main extension plane. In particular, the first shielding portion has a further first main surface and a further second main surface being connected by a further first side surface and a further second side surface. Exemplarily, the further first main surface and the further second main surface extend along the further first main extension plane and the further first side surface and the further second side surface extend traverse to the further first main extension plane.

Exemplarily, the second surface of the gate line is formed of the first main surface, the second main surface, the first side surface or the second side surface, particularly being different from the first surface.

The first shielding portion and the gate line overlap at least regionally in view perpendicular to the predetermined direction, for example. In particular, a least one of the further sections of the gate line and the first shielding portion overlap at least regionally or completely in view perpendicular to the predetermined direction.

Advantageously, the first surface of the gate line overlaps with the first auxiliary signal line and the second surface of the gate line overlaps with the first shielding portion, or vice versa. Thus, at least two surfaces, i.e. the first surface and the second surface, of the gate line are covered by the first auxiliary signal line and the first shielding portion. Advantageously, the gate inductance is thus reduced.

As, for example, a length of the auxiliary loop structure cannot be shortened, the first shielding portion is configured to reduce the gate inductance but also to influence the coupling commutation between the main loop or power loop and the gate line, i.e. a gate loop.

In summary, such an auxiliary loop structure advantageously reduces the gate inductance, such that the generation of voltage and current and/or voltage oscillations during switching is reduced. This facilitates a higher switching frequency, which is important for novel power semiconductor devices, in particular wide bandgap power semiconductor devices.

Further, influence on the coupling commutation is achieved with the auxiliary loop structure such that the coupling commutation can be more homogeneous, at least between groups of power semiconductor devices e.g. between high side and low side devices, and that a slightly negative coupling commutation is further advantageously achieved.

According to a further embodiment of the power semiconductor device, the first shielding portion is electrically conductively connected to the first auxiliary signal line. Exemplarily, the first shielding portion and the first auxiliary signal line are in direct contact with one another. Alternatively, an electrically conductive connection portion is arranged between the first shielding portion and the first auxiliary signal line.

According to a further embodiment of the power semiconductor device, the first shielding portion is electrically conductively connected to an electrical ground potential of the power semiconductor device. Exemplarily, the first shielding portion is electrically conductively connected to a baseplate of the power semiconductor device.

It is also conceivable that the first shielding portion is on an auxiliary emitter potential, e.g., the first shielding portion is electrically connected to the first auxiliary signal line. Alternatively, the first shielding portion is on any other auxiliary potential, such that the same potential used for NTC or any other sensor could be used to shield the gate line.

According to a further embodiment, the power semiconductor device further comprises a second shielding portion electrically conductively connected to the first shielding portion, wherein the second shielding portion at least regionally overlaps with a third surface of the shielded auxiliary signal line, e.g. the gate line. Exemplarily, the second shielding portion extends within a further second main extension plane being traverse, e.g. perpendicular, to the further first main extension plane of the first shielding portion and/or being parallel to the main extension plane of the first auxiliary signal line.

Exemplarily, the third surface of the gate line is formed of the first main surface, the second main surface, the first side surface or the second side surface, particularly being different from the first surface and the second surface.

The second shielding portion and the gate line overlap at least regionally in view along the predetermined direction, for example. In particular, at least one of the further sections of the gate line and the second shielding portion overlap at least regionally or completely in the view perpendicular to the predetermined direction. Exemplarily, the first auxiliary signal line, the gate line and the second shielding portion are arranged stacked above one another and/or are arranged next to one another along the predetermined direction, in particular in the indicated order.

According to a further embodiment, the power semiconductor device further comprises a third shielding portion electrically conductively connected to the first shielding portion, wherein the third shielding portion at least regionally overlaps with a fourth surface of the shielded auxiliary signal line, e.g. the gate line. In particular, the third shielding portion is electrically conductively and directly connected to the second shielding portion and/or with the auxiliary signal line. Exemplarily, the third shielding portion extends within a further third main extension plane being traverse, e.g. perpendicular, to the further second main extension plane of the second shielding portion and/or being parallel to the further first main extension plane of the first shielding portion.

Exemplarily, the fourth surface of the gate line is formed of the first main surface, the second main surface, the first side surface or the second side surface, particularly being different from the first surface, the second surface and the third surface.

The third shielding portion and the gate line overlap at least regionally in view perpendicular to the predetermined direction, for example. In particular, at least one of the further sections of the gate line and the third shielding portion overlap at least regionally or completely in view perpendicular to the predetermined direction. Exemplarily, the first shielding portion, the gate line and the third shielding portion are arranged stacked above one another and/or are arranged next to one another perpendicular to the predetermined direction, in particular in the indicated order.

According to a further embodiment, the power semiconductor device further comprises a cover body. The cover body is configured, in particular, to space apart the gate line and the first auxiliary signal line from one another as well as to electrically insulate the gate line from the first auxiliary signal line. For example, power terminal, in particular the drain terminal or the collector terminal and/or the emitter terminal or the source terminal are embedded in the cover body.

Exemplarily, the cover body is formed of an electrically insulating material, such as a resin material. The resin material comprises, for example, a thermosetting resin or a thermoplastic resin. The resin material can further comprise a filler. The filler is formed, for example, of at least one of fibers and particles, e.g. formed of an inorganic material such as a ceramic.

According to a further embodiment of the power semiconductor device, the gate line and/or the first auxiliary signal line is at least regionally embedded in the cover body. "Embedded" in the cover body means here that at least one outer surface, i.e. the first main surface, the second main surface, the first side surface or the second side surface, or all outer surfaces, is covered by the cover body, in particular so that the surfaces and the cover body are in direct contact to one another.

According to a further embodiment of the power semiconductor device, the first shielding portion is arranged on a first main surface of the cover body. In particular, the first shielding portion is in direct contact to the cover body. Exemplarily, the second shielding portion is arranged on a second main surface of the cover body. Exemplarily, the third shielding portion is arranged on a third main surface of the cover body.

Advantageously, an embedding of the auxiliary loop structure can used for alignment purposes. The cover body is, for example, mainly used to form a terminal block incorporating the main terminal and/or auxiliary terminal. Thus, the cover body advantageously forms a common building block, which makes the power semiconductor device assembly easier.

According to a further embodiment, the power semiconductor device further comprises a first auxiliary connection portion and a second auxiliary connection portion between which the first auxiliary signal line is arranged. Exemplarily, the second auxiliary connection portion is connected to the first signal line.

According to a further embodiment, the power semiconductor device further comprises a first gate connection portion and a second gate connection portion between which the gate line is arranged. Exemplarily, the second gate connection portion is connected to the second signal line.

According to a further embodiment, the power semiconductor device, the first auxiliary connection portion and the first gate connection portion are each at least partially free of the cover body. Exemplarily, the first auxiliary connection portion and the first gate connection portion are each configured to be contactable externally.

According to a further embodiment of the power semiconductor device, the first shielding portion is formed in one piece with the first auxiliary signal line or the second auxiliary signal line. Exemplarily, the second shielding portion and/or the third shielding portion is formed in one piece with the first auxiliary signal line.

According to a further embodiment of the power semiconductor device, the first shielding portion is formed as an electrically conductive coating. Exemplarily, the second shielding portion and/or the third shielding portion is formed as an electrically conductive coating.

The first shielding portion comprises, for example, an electroconductive material such as a metal or a conductive polymer. The conductive polymer is in particular configured for coating a resin surface, e.g. the cover body.

According to a further embodiment of the power semiconductor device, the main extension direction of the first auxiliary signal line is parallel to the further first main extension direction of the first shielding portion and the main extension plane of the first auxiliary signal line is traverse to the further first main extension plane of the first shielding portion.

According to a further embodiment of the power semiconductor device, the first shielding portion faces the power line and/or the power terminal. Exemplarily, the first shielding portion faces the power semiconductor chip, which can comprise bonding wires.

A further embodiment relates to a method for producing a power semiconductor device, in particular, a power semiconductor device as described herein above. Therefore, the features as described in connection with the method are also applicable for the power semiconductor device and vice versa.

According to the embodiment, a power line is provided electrically connected to the power terminal.

According to the embodiment, at least two auxiliary terminals are provided wherein one of the at least two terminals is a gate terminal and at least two auxiliary signal lines are provided comprising a first auxiliary signal line and a second auxiliary signal line where the first auxiliary signal line is electrically connected to the power terminal and the second auxiliary signal line is a gate line (4) electrically connected to the gate terminal, and the at least two auxiliary signal lines are spaced apart from one another and extend at least regionally parallel to each other.

The first auxiliary signal line and/or the gate line are exemplarily formed of a metal sheet. The metal sheet is in particular produced by stamping or etching. The produced metal sheet can subsequently be bent to form the sections and/or the further sections.

According to the embodiment, a first shielding portion is formed for shielding one of the at least two auxiliary signal lines from an electromagnetic field of the power line, formed electrically conductive, spaced apart from the shielded auxiliary signal line, and extending at least regionally parallel to the at least two auxiliary signal lines.

According to the embodiment of the method, the at least two auxiliary signal lines at least regionally overlap with each other where a first surface of the shielded auxiliary signal line is covered by the other auxiliary signal line.

According to the embodiment of the method, the first shielding portion (5) at least regionally overlaps with a second surface of the shielded auxiliary signal line.

According to a further embodiment of the method, a cover body is applied to the gate line and/or the auxiliary signal line so that the gate line and/or the auxiliary signal line is at least regionally embedded in the cover body. The cover body is applied, for example, by injection moulding or transfer moulding.

The cover body comprises, exemplarily, a resin.

According to a further embodiment of the method, a material of the first shielding portion is applied on a first main surface of the cover body.

According to a further embodiment of the method, a further cover body is applied to the cover body and/or the first shielding portion. The cover body or the cover body and the further cover body, for example, form or is part of a housing block or a terminal block of the power semiconductor device.

Advantageously, for the application of the cover body and the further cover body, a two-step molding process is used. In a first molding process, the auxiliary loop structure is embedded in the cover body, where at least one surface or at least one contact portion of the auxiliary loop structure is free of the cover body. Subsequently, the first shielding portion is applied as an electrically conductive coating on one or more main surfaces of the cover body, i.e. forming the first shielding portion, the second shielding portion and/or the third shielding portion. Subsequently, the further cover body is applied to the cover body with the first shielding portion to form the final housing block or terminal block.

Advantageously, a perfect coaxial arrangement comprising the first shielding portion, the second shielding portion, the third shielding portion and the first auxiliary signal line is formed around the gate line.

According to a further embodiment of the method, the first auxiliary signal line comprises at least regionally extended regions. The extended regions are formed, exemplarily, in one piece with the first auxiliary signal line. Alternatively, the extended regions are attached to the first auxiliary signal line, for example, by a bonding process.

According to a further embodiment of the method, the extended regions are bend for forming the first shielding portion such that a further first main extension plane of the first shielding portion is traverse to a main extension plane of the first auxiliary signal line. A bending angle is between 0° and 180°, e.g. approximately 90°. Exemplarily, the first auxiliary signal line and the first shielding portion are formed as an integral part.

The accompanying Figures are included to provide a further understanding. In the Figures, elements of the same structure and/or functionality may be referenced by the same reference signs. It is to be understood that the embodiments shown in the Figures are illustrative representations and are not necessarily drawn to scale.
Figure 1 shows a schematic view of an auxiliary loop structure of a power semiconductor device according to an exemplary embodiment.
Figure 2 shows a schematic view of a method step for forming the auxiliary loop structure of a power semiconductor device according to an exemplary embodiment.
Figure 3 shows a schematic view of an auxiliary loop structure of a power semiconductor device according to an exemplary embodiment.
Figure 4 shows an auxiliary loop structure as an example.
Figures 5, 6 and 7 each show a schematic view of an auxiliary loop structure of a power semiconductor device according to an exemplary embodiment.
Figure 8 shows a schematic view of a power semiconductor device according to an exemplary embodiment.

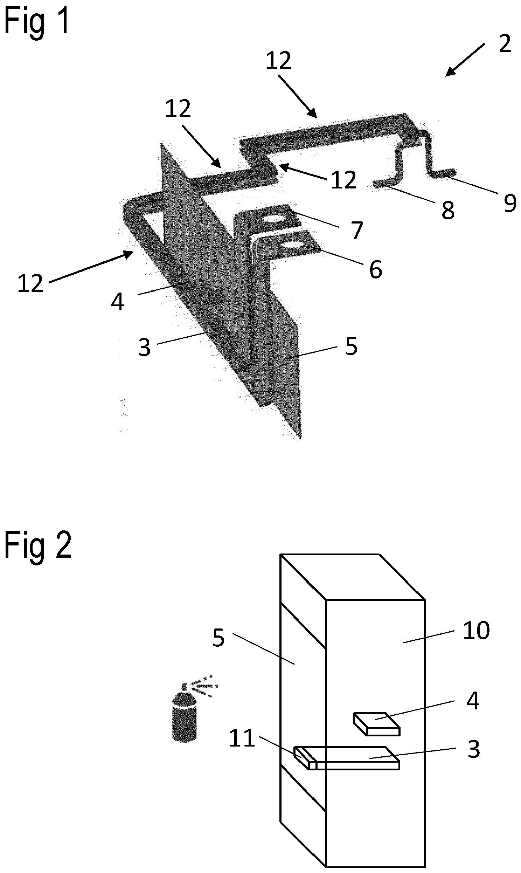

The auxiliary loop structure 2 of a power semiconductor device 1 according to the exemplary embodiment of Figure 1 comprises a first auxiliary signal line 3 and a gate line 4. The first auxiliary signal line 3 comprises a plurality of sections and the gate line 4 comprises a plurality of further sections. The sections and the further sections have, in particular, the same width, the same thickness and/or the same height.

The first auxiliary signal line 3 and the gate line 4 each extend within a main extension plane, wherein the main extension planes are parallel to one another. A predetermined direction is defined perpendicular to the main extension plane of the first auxiliary signal line 3. The sections 12 and the further sections are arranged above one another along the predetermined direction. In particular, the first auxiliary signal line 3 and the gate line 4 are arranged parallel to one another. That is, each main extension direction of each segment is parallel to a corresponding main extension direction of a corresponding further segment.

The segments and the further segments overlap with one another in view along the predetermined direction, in particular to a large extent. "A large extent" means that at least some or all of the segments and at least some or all of the further segments overlap by at least 20 %, least 50 % or at least 80 % or in particular completely.

The first auxiliary signal line 3 and the gate line 4 each have a first main surface and a second main surface being connected by a first side surface and a second side surface. The second main surface of the first auxiliary signal line 3 faces the first main surface of the gate line 4, in particular the second main surface of the first auxiliary signal line 3 and the first main surface (also referred as first surface) of the gate line 4 are arranged directly opposite to one another. That is, the second main surface (also referred as second surface)of the first auxiliary signal line 3, particularly to a large extent, covers the first main surface of the gate line 4 - i.e. being the first surface of the gate line 4.

For better electromagnetic properties, the first auxiliary signal line 3 and the gate line 4 form a more effective gate loop (auxiliary signal loop) with a lower loop area, resulting in an increased mutual inductive coupling between them to reduce the gate inductance (self-inductance of the gate) and minimize effect of magnetic coupling from a power loop (reduce influence on the coupling commutation between the power loops and gate). Thus, the auxiliary loop structure comprising at least two auxiliary signal lines (for example, first auxiliary signal line and a second signal line (gate line) are so designed to maximize inductive coupling between them by placing the two auxiliary signal lines parallel and close to each other, and forming a shielding portion (5) using one of the auxiliary signal line or with a line that is at a ground potential.

The auxiliary loop structure includes structure that covers a shielded line (e.g. a gate line) which is one of the at least two auxiliary signal lines around one or more surfaces (for e.g. first surface, second surface) of shielded line for increased inductive/ magnetic coupling between the at least two auxiliary signal lines. Later, in the further embodiments of the invention, auxiliary loop structure that covers the shielded line (e.g. gate line) in all the sides i.e. first surface, second surface, third surface and fourth surface, are disclosed. In the embodiments, though the surface of the shielded line and the shield portion are generally shown as rectangular, the surface of the shielded line and the shield portion including the portions that cover the shielded line can also be of other shapes, for e.g. circular or oval, and the partitions as first, second, third or fourth surface can be additionally described with arc angles covered by such surfaces.

The auxiliary loop structure 2 of a power semiconductor device 1 further comprises a first auxiliary connection portion 6 and a second auxiliary connection portion 8 between which the first auxiliary signal line 3 is arranged, and a first gate connection portion 7 and a second gate connection portion 9 between which the gate line 4 is arranged.

The auxiliary loop structure 2 further comprises a first shielding portion 5. One of the sections 12 of the first auxiliary signal line 3 is provided with the first shielding portion 5. The first shielding portion 5 and the gate line 4 are electrically insulated from one another and have a distance to one another. Further, the first shielding portion 5 is electrically conductively connected to the first auxiliary signal line 3.

The first shielding portion 5 extends in a further first main extension plane being perpendicular to the main extension plane of the first auxiliary signal line 3. Furthermore, a further first main extension direction of the first shielding portion 5 is parallel to the main extension direction of the section 12 of the first auxiliary signal line 3, which is provided with the first shielding portion 5.

The first shielding portion 5 has a further first main surface and a further second main surface being connected by a further first side surface and a further second side surface. The further first main surface of the first shielding portion 5 faces the first side surface of the gate line 4, in particular the further first main surface of the first shielding portion 5 and the first side surface of the gate line 4 are arranged directly opposite to one another. This is, the further first main surface of the first shielding portion 5, particularly to a large extent, covers the first side surface of the gate line 4 - i.e. being the second surface of the gate line 4.

When forming the auxiliary loop structure 2 according to Figure 2, a cover body 10 is applied to the gate line 4 and the first auxiliary signal line 3 so that the gate line 4 and the first auxiliary signal line 3 are at least regionally embedded in the cover body 10. Subsequently, a material of the first shielding portion 5 is applied on a first main surface of the cover body 10. The material of the first shielding portion 5 is applied, e.g. by spraying.

The first shielding portion 5 is electrically conductively connected to the first auxiliary signal line 3 by an electrically conductive connection portion 11. The electrically conductive connection portion 11 is also embedded in the cover body 10.

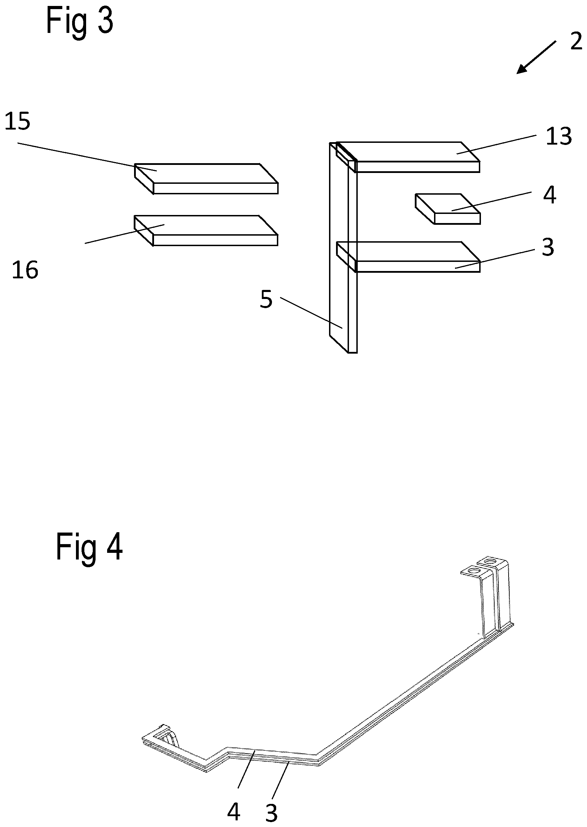

The auxiliary loop structure 2 of the power semiconductor device 1 according to the exemplary embodiment of Figure 3 has, in addition to the auxiliary loop structure 2 of Figure 1, a second shielding portion 13. The second shielding portion 13 is directly and electrically conductively connected to the first shielding portion 5.

The second shielding portion 13 extends in a further second main extension plane being parallel to the main extension plane of the first auxiliary signal line 3. Further, a further second main extension direction of the second shielding portion 13 is parallel to the main extension direction of the section 12 of the first auxiliary signal line 3, which is provided with the second shielding portion 13.

The second shielding portion 13 has a further first main surface and a further second main surface being connected by a further first side surface and a further second side surface. The further first main surface of the second shielding portion 13 faces the second main surface of the gate line 4, in particular the further first main surface of the second shielding portion 13 and the second main surface of the gate line 4 are arranged directly opposite to one another. That is, the further first main surface of the second shielding portion 13, particularly to a large extent, covers the second main surface of the gate line 4 - i.e. being the third surface of the gate line 4.

The first shielding portion 5 and the second shielding portion 13 advantageously shield the gate line 4 from a magnetic field from the power line 16 and/or the power terminal 17.

In contrast to the auxiliary loop structure according to Figure 1, the exemplary auxiliary loop structure according to the example of Figure 4 does not comprise a shielding portion.

Exemplary finite element simulations are performed for indicating an effect of the shielding portion, in particular for indicating a gate inductance and a coupling commutation of the gate line 4. Exemplarily, the simulations show the electromagnetic and coupling commutation behavior of a half-bridge power semiconductor device 1 with auxiliary loop structures 2, which are extending over long distances. The gate inductance of the gate line 4, as well as a coupling commutation corresponding to a high side, HS, circuitry and a low side, LS, circuitry of the power semiconductor device 1, are calculated respectively.

The gate inductance corresponding to the HS is 73,80 nH and for the LS is 66,76 nH. The coupling commutation corresponding to the HS is -0,017 nH and for the LS is 0,105 nH.

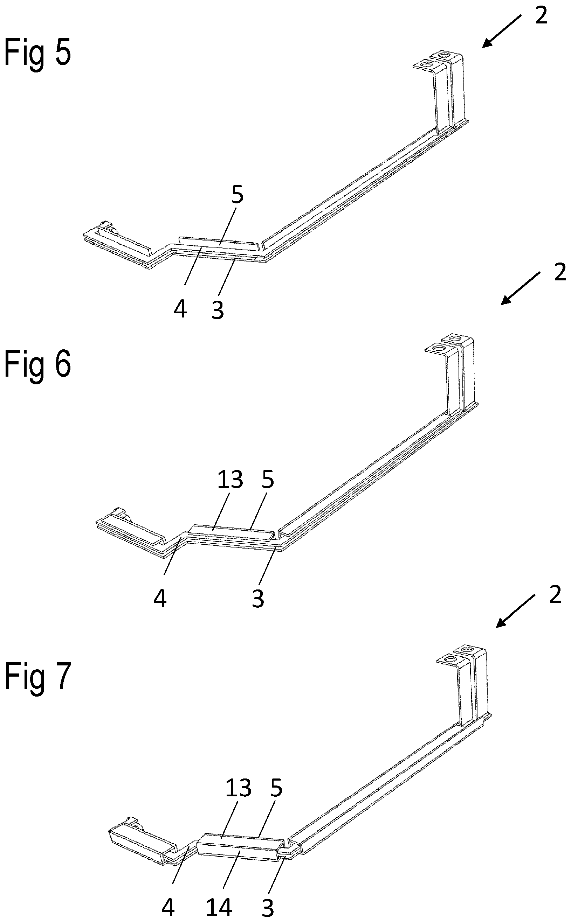

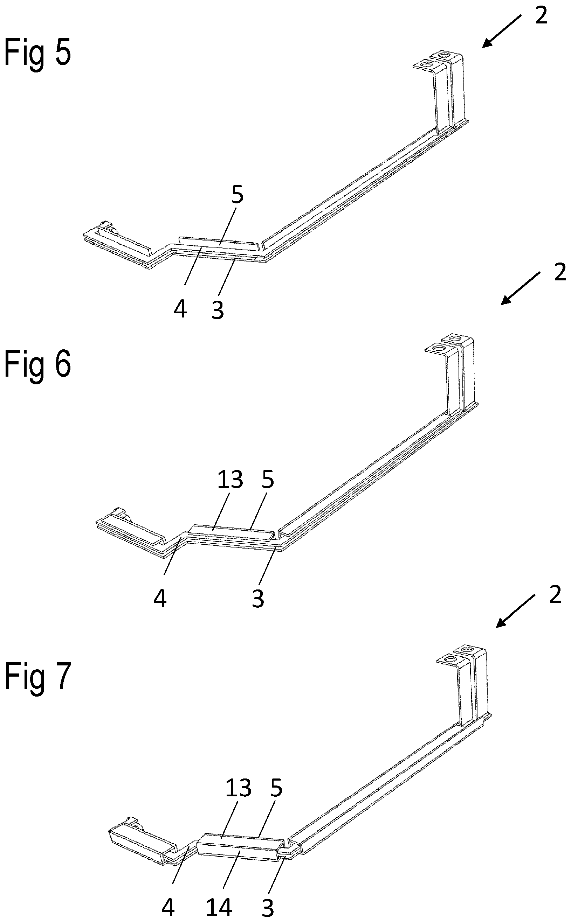

In contrast to the exemplary auxiliary loop structure 2, the auxiliary loop structure 2 according to the exemplary embodiment of Figure 5 comprises a first shielding portion, as also shown in Figure 1.

The gate inductance corresponding to the HS is reduced to 63,96 nH and for the LS reduced to 59,90 nH. The coupling commutation corresponding to the HS is -0,003 nH and for the LS 0,075 nH.

In contrast to the exemplary auxiliary loop structure 2, the auxiliary loop structure 2 according to the exemplary embodiment of Figure 6 comprises a first shielding portion and a second shielding portion 13, as also shown in Figure 3.

The gate inductance corresponding to the HS is reduced to 58,53 nH and for the LS reduced to 56,44 nH. The coupling commutation corresponding to the HS is 0,021 nH and for the LS is 0,073 nH.

In contrast to the exemplary auxiliary loop structure 2, the auxiliary loop structure 2 according to the exemplary embodiment of Figure 7 comprises a first shielding portion and a second shielding portion 13 as also shown in Figure 3, as well as a third shielding portion.

The gate inductance corresponding to the HS is 56,30 nH and for the LS 54,61 nH. The coupling commutation corresponding to the HS is 0,020 nH and for the LS is 0,076 nH.

The third shielding portion 14 extends in a further third main extension plane being perpendicular to the main extension plane of the first auxiliary signal line 3. Furthermore, a further third main extension direction of the third shielding portion 14 is parallel to the main extension direction of the section 12 of the first auxiliary signal line 3 which is provided with the third shielding portion 14.

The third shielding portion 14 has a further first main surface and a further second main surface being connected by a further first side surface and a further second side surface. The further first main surface of the third shielding portion 14 faces the second side surface of the gate line 4. In particular the further first main surface of the third shielding portion 14 and the second side surface of the gate line 4 are arranged directly opposite to one another. That is, the further first main surface of the third shielding portion 14, particularly to a large extent, covers the second side surface of the gate line 4 - i.e. being the fourth surface of the gate line 4.

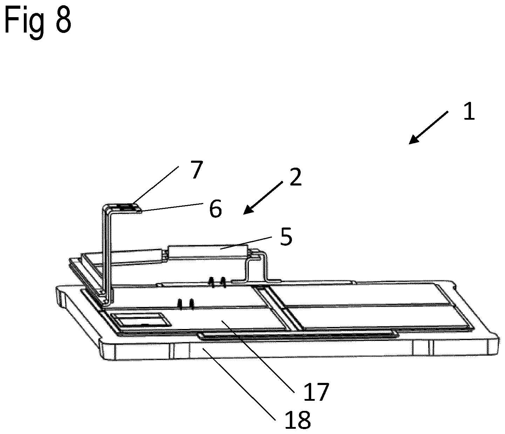

The a power semiconductor device 1 according to the exemplary embodiment of Figure 8 comprises an auxiliary loop structure 2, e.g. according to Figure 5, as well as semiconductor chips 17 arranged on a carrier 18.

The exemplary embodiments, in particular features of the exemplary embodiments, of the Figures can be combined with one another.

### Reference Signs

- 1: power semiconductor device
- 2: auxiliary loop structure
- 3: first auxiliary signal line
- 4: gate line
- 5: first shielding portion
- 6: first auxiliary connection portion
- 7: first gate connection portion
- 8: second auxiliary connection portion
- 9: second gate connection portion
- 10: cover body
- 11: electrically conductive connection portion
- 12: section
- 13: second shielding portion
- 14: third shielding portion
- 15: power terminal
- 16: power line
- 17: semiconductor chip
- 18: carrier

## Claims

1. Power semiconductor device (1), with
- a power line (16) electrically connected to a power terminal (17), and
- an auxiliary loop structure (2) comprising
- at least two auxiliary terminals wherein one of the at least two terminals is a gate terminal,
- at least two auxiliary signal lines (3, 4) comprising a first auxiliary signal line and a second auxiliary signal line where the first auxiliary signal line is electrically connected to the power terminal (17) and the second auxiliary signal line is a gate line (4) electrically connected to the gate terminal, and the at least two auxiliary signal lines are spaced apart from one another and extend at least regionally parallel to each other, and
- a first shielding portion (5) for shielding one of the at least two auxiliary signal lines from an electromagnetic field of the power line (16), formed electrically conductively, spaced apart from the shielded auxiliary signal line (4), and extending at least regionally parallel to the at least two auxiliary signal lines (3), wherein
- the at least two auxiliary signal lines (3, 4) at least regionally overlap with each other where a first surface of the shielded auxiliary signal line (3, 4) is covered by the other auxiliary signal line (3, 4), and
- the first shielding portion (5) at least regionally overlaps with a second surface of the shielded auxiliary signal line (3, 4).

2. Power semiconductor device (1) according to claim 1, wherein
- the first shielding portion (5) is electrically conductively connected to the first auxiliary signal line (3), or
- the first shielding portion (5) is electrically conductively connected to an electrical ground potential of the power semiconductor device (1).

3. Power semiconductor device (1) according to one of claims 1 or 2, further comprising
- a second shielding portion (13) electrically conductively connected to the first shielding portion (5), wherein the second shielding portion (13) at least regionally overlaps with a third surface of the shielded auxiliary signal line (3, 4), and/or
- a third shielding portion (14) electrically conductively connected to the first shielding portion (5), wherein the third shielding portion (14) at least regionally overlaps with a fourth surface of the gate line (4).

4. Power semiconductor device (1) according to one of claims 1 to 3, further comprising
- a cover body (10), wherein
- the gate line (4) and/or the first auxiliary signal line (3) is at least regionally embedded in the cover body (10), and
- the first shielding portion (5) is arranged on a first main surface of the cover body (10).

5. Power semiconductor device (1) according to one of claims 1 to 4, further comprising
- a first auxiliary connection portion (6) and a second auxiliary connection portion (8) between which the first auxiliary signal line (3) is arranged, and
- a first gate connection portion (7) and a second gate connection portion (9) between which the gate line (4) is arranged.

6. Power semiconductor device (1) according to claims 4 and 5, wherein
- the first auxiliary connection portion (6) and the first gate connection portion (7) are each at least partially free of the cover body (10).

7. Power semiconductor device (1) according to one of claims 1 to 6, wherein
- the first shielding portion (5) is formed in one piece with the first auxiliary signal line (3) or the second auxiliary signal line (4), or
- the first shielding portion (5) is formed as an electrically conductive coating on the first main surface of the cover body.

8. Power semiconductor device (1) according to one of claims 1 to 7, wherein
- a main extension direction of the first auxiliary signal line (3) is parallel to a further first main extension direction of the first shielding portion (5), and
- the main extension plane of the first auxiliary signal line (3) is traverse to the further first main extension plane of the first shielding portion (5).

9. Power semiconductor device (1) according to one of claims 1 to 8, wherein
- the first shielding portion (5) faces the power line (16) and/or the power terminal (17).

10. Method for producing a power semiconductor device (1), comprising
- providing a power line (16) electrically connected to a power terminal (17),
- providing an auxiliary loop structure (2) comprising
- at least two auxiliary terminals wherein one of the at least two terminals is a gate terminal,
- at least two auxiliary signal lines (3, 4) comprising a first auxiliary signal line and a second auxiliary signal line where the first auxiliary signal line is electrically connected to the power terminal (17) and the second auxiliary signal line is a gate line (4) electrically connected to the gate terminal, and the at least two auxiliary signal lines (3, 4) are spaced apart from one another and extend at least regionally parallel to each other, and
- forming a first shielding portion (5) for shielding one of the at least two auxiliary signal lines (3, 4) from an electromagnetic field of the power line (16), formed electrically conductive, spaced apart from the shielded auxiliary signal line (4), and extending at least regionally parallel to the at least two auxiliary signal lines (3, 4) wherein
- the at least two auxiliary signal lines (3, 4) at least regionally overlap with each other where a first surface of the shielded auxiliary signal line (3, 4) is covered by the other auxiliary signal line (3, 4), and
- the first shielding portion (5) at least regionally overlaps with a second surface of the shielded auxiliary signal line (3, 4).

11. Method according to claim 10, wherein
- a cover body (10) is applied to the gate line (4) and/or the first auxiliary signal line (3) so that the gate line (4) and/or the first auxiliary signal line (3) is at least regionally embedded in the cover body (10).

12. Method according to claim 11, wherein
- a material of the first shielding portion (5) is applied on at least one surface of the cover body (10).

13. Method according to claim 12, wherein
- a further cover body (10) is applied to the cover body (10) and/or the first shielding portion (5).

14. Method according to claim 11, wherein
- the auxiliary signal line (3) comprises at least regionally extended regions, and
- the extended regions are bent for forming the first shielding portion (5) such that a further first main extension plane of the first shielding portion (5) is traverse to a main extension plane of the first auxiliary signal line (3).
